# EUROPEAN PATENT APPLICATION

(11) **EP 2 947 472 A1**
(43) Date of publication of application: **25.11.2015**
(21) Application number: 14188091.4
(22) Date of filing: 08.10.2014
(51) Int. Cl.: G01R 33/09

(54) **Anisotropic magnetoresistive device and method for fabricating the same**

(30) Priority: 22.05.2014 TW 103117948
(71) Applicant: Voltafield Technology Corp., Hsinchu County 302 (TW)
(72) Inventor: Liou, Fu-Tai, 302 Hsinchu County (TW); Lee, Chien-Min, 31055 Hsinchu County (TW)
(74) Representative: Straus, Alexander

(57) **Abstract**

The present invention relates to an anisotropic magnetoresistive (AMR) device which comprises a substrate, an interconnect structure and a magnetoresistive material layer. The interconnect structure is disposed above the substrate and comprises a plurality of metal interconnect layers. The magnetoresistive material layer is disposed above the interconnect structure. The topmost metal interconnect layer of the plurality of metal interconnect layers comprises a conductive current-shunting structure. The conductive current-shunting structure is physically connected to the magnetoresistive layer without a conductive via plug.

## Description

### BACKGROUND OF THE INVENTION

### Field of Invention

The present invention relates to a magnetoresistive device and a method for fabricating the same, particularly to a anisotropic magnetoresistive device and a method for fabricating the same.

### Description of Related Art

The magnetoresistive material(s) used in a magnetoresistive device would change its resistance according to a change of an external magnetic field. This kind of material(s) is popular for sport equipments, automobile, motors and communication products. Common magnetoresistive materials can be categorized into anisotropic magnetoresistive material (AMR), giant magnetoresistive material (GMR) and tunneling magnetoresistive material (TMR) according to how they function and their sensitivities.

Specifically, the change of resistance of a magnetoresistive material depends on an included angle between the direction of electrical current flowing in the magnetoresistive material and the direction of the external magnetic field applied. When the direction of electrical current is parallel to the direction of the external magnetic field, the resistance reaches its maximum value; when the direction of electrical current deviates from the direction of the external magnetic field, the resistance would decrease from its maximum value; when the direction of electrical current is perpendicular to the direction of the external magnetic field, the resistance reaches its minimum value.

To achieve better sensitivity, it is desired that the resistance of a magnetoresistive material would change with a change of the direction of an external magnetic field linearly. Linear resistance response may be achieved by forming spiral-shaped barber pole strips on the magnetoresistive material. Barber pole strips are usually made of aluminum or gold. Their stretching direction forms about 45 degree with the stretching direction of the magnetoresistive material so as to shunt electrical current flowing in the magnetoresistive material and change the direction of the electrical current.

The geometric characteristics of the magnetoresistive material and the barber pole strips, their relative location, their sizes and their materials would not only affect the performance of a magnetoresistive device but also affect the manufacturing process of the magnetoresistive device. The industry is still looking for a magnetoresistive device with optimal performance which can be made easily and economically and has optimal performance.

### SUMMARY OF THE INVENTION

The object of this invention is to provide a magnetoresistive device, especially a magnetoresistive device with optimal performance made easily and economically.

The present invention provides an anisotropic magnetoresistive (AMR) device which comprises a substrate, an interconnect structure and a magnetoresistive material layer. The interconnect structure is disposed above the substrate and comprises a plurality of metal interconnect layers. The magnetoresistive material layer is disposed above the interconnect structure. The topmost metal interconnect layer of the plurality of metal interconnect layers comprises a conductive current-shunting structure. The conductive current-shunting structure is physically connected to the magnetoresistive material layer without a conductive via plug.

In one embodiment of the present invention, no metal interconnect layers are disposed above the magnetoresistive material layer but optional redistribution layer(s) (RDL) may be disposed above the magnetoresistive material layer. On the magnetoresistive material layer, there may be an optional hard mask layer and an optional passivation layer. Right under the magnetoresistive material layer, there may be optional active devices.

In one embodiment of the present invention, the topmost metal interconnect layer further comprises a bonding pad substantially made of copper or aluminum.

In one embodiment of the present invention, the plurality of metal interconnect layers further comprises a set/reset circuit, a compensating circuit and/or a built-in self-testing circuit disposed right under the magnetoresistive material layer.

In one embodiment of the present invention, the surface roughness of the conductive current-shunting structure at a boundary between the conductive current-shunting structure and the magnetoresistive material layer is less than 500 Angstroms.

In one embodiment of the present invention, the conductive current-shunting structure is embedded in an inter-metal dielectric layer and a kink (step height) between an upper primary surface of the conductive current-shunting structure and an upper primary surface of the inter-metal dielectric layer is less than 1000 Angstroms.

The present invention provides a method for forming an anisotropic magnetoresistive (AMR) device. This method comprises a step of providing a substrate and a step of forming an interconnect structure above the substrate. The interconnect structure comprises a plurality of metal interconnect layers, wherein a topmost metal interconnect layer of the plurality of metal interconnect layers comprises a conductive current-shunting structure. The method further comprises a step of forming a magnetoresistive material layer, whereby the conductive current-shunting structure is physically connected to the magnetoresistive layer without a conductive via plug.

In one embodiment of the present invention, the method further comprises, before the step of forming the magnetoresistive layer, a step of optionally performing a chemical mechanical polishing process and/or a surface treatment and/or an anneal process to the topmost interconnect layer to make it flatter and reduce its surface roughness.

In one embodiment of the present invention, the conductive current-shunting structure is substantially made of copper or tungsten and formed by a damascene process.

In one embodiment of the present invention, the conductive current-shunting structure is made by patterning aluminum.

In the traditional manufacturing processes known to a person skilled in the art, since the magnetoresistive material layer is formed on the substrate first and then the back end interconnect structure is formed, the magnetoresistive material used for the magnetoresistive material layer containing magnetic species such as iron, cobalt and nickel may contaminate machines used for the back end interconnect processes and affect performance of devices of the front end of line such as transistors and diodes. Furthermore, in the traditional manufacturing processes, since the back end interconnect structure is formed after the magnetoresistive material layer is formed, the processes used to form the back end interconnect structure such as deposition process, etching process and lithography process, the materials used to form the back end interconnect structure such as chemical precursors, organic solvents, photoresist and plasma, and the process parameters used to form the back end interconnect structure such as excessive high temperature and pressure may affect reliability and performance of the anisotropic magnetoresistive device adversely.

In summary, in the anisotropic magnetoresistive device according to various embodiments of the present invention, the magnetoresistive material layer is former after the completion of the front end of line (FEOL) and the back end interconnect processes. Therefore, the magnetoresistive material used for the magnetoresistive material layer containing magnetic species such as iron, cobalt and nickel can not contaminate machines used for the front end of line and back end interconnect processes. Moreover, since the front end of line and back end interconnect processes are completed before forming the magnetoresistive material layer, the processes, materials, parameters used in the front end of line and back end interconnect processes can not affect the magnetoresistive material layer formed later.

Furthermore, the present invention controls the surface roughness of the upper primary surface of the conductive current-shunting structure which is at the boundary between the magnetoresistive material layer and the conductive current-shunting structure and controls the kink (step height) between the upper primary surface of the conductive current-shunting structure and the upper primary surfaces of the inter-metal dielectric layer IMDₓ or IMDₓ₊₁, so currents following in the current-shunting structure during operation of the anisotropic magnetoresistive device can have better orientation and distribution, thereby achieving better performance of the anisotropic magnetoresistive device.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.
Fig. 1 shows the schematic diagram illustrating the anisotropic magnetoresistive device according to one embodiment of the present invention;
Fig. 1A shows the schematic diagram illustrating the current flow within the anisotropic magnetoresistive device according to one embodiment of the present invention;
Fig. 2 shows the schematic cross-sectional view of the anisotropic magnetoresistive device taken along line A-A' of Fig. 1 according to the first embodiment of the present invention;
Fig. 3 shows the schematic cross-sectional view of the anisotropic magnetoresistive device taken along line A-A' of Fig. 1 according to the second embodiment of the present invention;
Fig. 4 shows the schematic cross-sectional view of the anisotropic magnetoresistive device taken along line A-A' of Fig. 1 according to the third embodiment of the present invention;
Fig. 5 shows the schematic cross-sectional view of the anisotropic magnetoresistive device taken along line A-A' of Fig. 1 according to the fourth embodiment of the present invention;
Fig. 6 shows the enlarged cross-sectional view of the boundary between the magnetoresistive material layer and the conductive current-shunting structure of Fig. 2 or fig. 4.
Fig. 7 shows the enlarged cross-sectional view of the boundary between the magnetoresistive material layer and the conductive current-shunting structure of Fig. 5.
Fig. 8 shows the current flow within the conductive current-shunting structures of Figs. 2-5.

### DESCRIPTION OF EMBODIMENTS

The following descriptions illustrate preferred embodiments of the present invention in detail. All the components, sub-portions, structures, materials and arrangements therein can be arbitrarily combined in any sequence despite their belonging to different embodiments and having different sequence originally. All these combinations are falling into the scope of the present invention. A person of ordinary skills in the art, upon reading the present invention, can change and modify these components, sub-portions, structures, materials and arrangements therein without departing from the spirits and scope of the present invention. These changes and modifications should fall in the scope of the present invention defined by the appended claims.

There are a lot of embodiments and figures within this application. To avoid confusions, similar components are designated by the same or similar numbers. To simplify figures, repetitive components are only marked once. The purpose of figures is to convey concepts and spirits of the present invention, so all the distances, sizes, scales, shapes and connections are explanatory and exemplary but not realistic. Other distances, sizes, scales, shapes and connections that can achieve the same functions or results in the same way can be adopted as equivalents.

In the context of the present invention, "magnetoresistive material layer" is composed by magnetic materials, especially discrete or continuous single layer or multiple layers whose resistance would change according to a change of an external magnetic field. For example, the magnetic material may comprise an anisotropic magnetoresistive material (AMR), a ferromagnet material, an antiferromagnet material, a nonferromagnet material or a tunneling oxide or any combination thereof. "Magnetoresistive material layer" preferably comprises anisotropic magnetoresistive material (AMR) especially Permalloy.

In the context of the present invention, "interconnect structure" comprises interconnect layer(s) made from metallic material(s), especially conductive interconnect layer(s) disposed within inter-layer dielectric layers (ILDs) or inter-metal dielectric layers (IMDs) and formed by patterning process, single damascene process, dual damascene process or a combination thereof. The "interconnect structure" usually comprise a plurality of metal wiring layers (the first metal wiring layer M1, the second metal wiring layer M2, the third metal wiring layer M3, etc.) and a plurality of metal via layers (the first metal via layer V1 between the first metal wiring layer M1 and the second metal wiring layer M2, the second metal via layer V2 between the second metal wiring layer M2 and the third metal wiring layer M3, the third metal via layer V3 between the third metal wiring layer M3 and the fourth metal wiring layer M4, etc.). Because different manufacturing processes and different materials may be adopted, a single metal wiring layer Mx (x is an integer) and the metal via layer immediately above or below this single metal wiring layer Mx may be separate structures that are formed separately but physically connected or one structure that are formed integrally.

In the context of the present invention, "substantially coplanar" is a term used to describe globally flat upper surfaces of different materials such as a dielectric material and a metallic material as being on the same vertical level. As such, the kink (step height) between the upper surfaces of these different materials such as a dielectric material and a metallic material is less than a predetermined range.

In the context of the present invention, "primary surface" is a globally flat upper surface or a globally flat lower surface of a material layer without considering local protrusions or local dents of this material layer.

In the context of the present invention, "redistribution layer (RDL)" is not a part of the interconnect structure. A redistribution layer (RDL) can re-route the connecting location of a bonding pad of original design to a new connecting location of flip chip design by a wafer-level routing process and a bump process. In the context of the present invention, a wafer-level routing process is performed by the following steps: after forming the magnetoresistive material layer, forming a passivation/protective layer on the substrate; defining wiring patterns by a lithography process; forming metal wiring by electroplating and/or etching processes. After the wafer-level routing process, gold pads or metallic bumps are formed to connect the bonding pads of original design through the redistribution layer (RDL) formed by the wafer-level routing process.

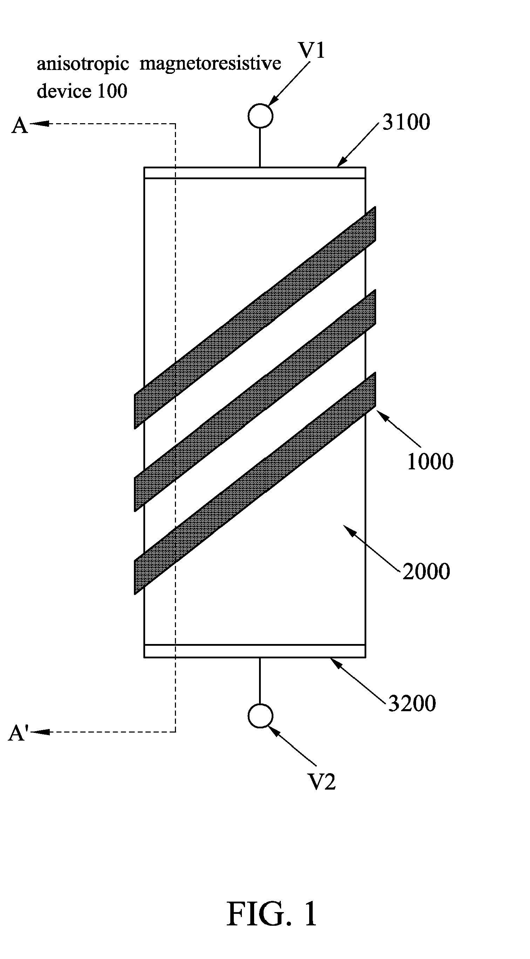

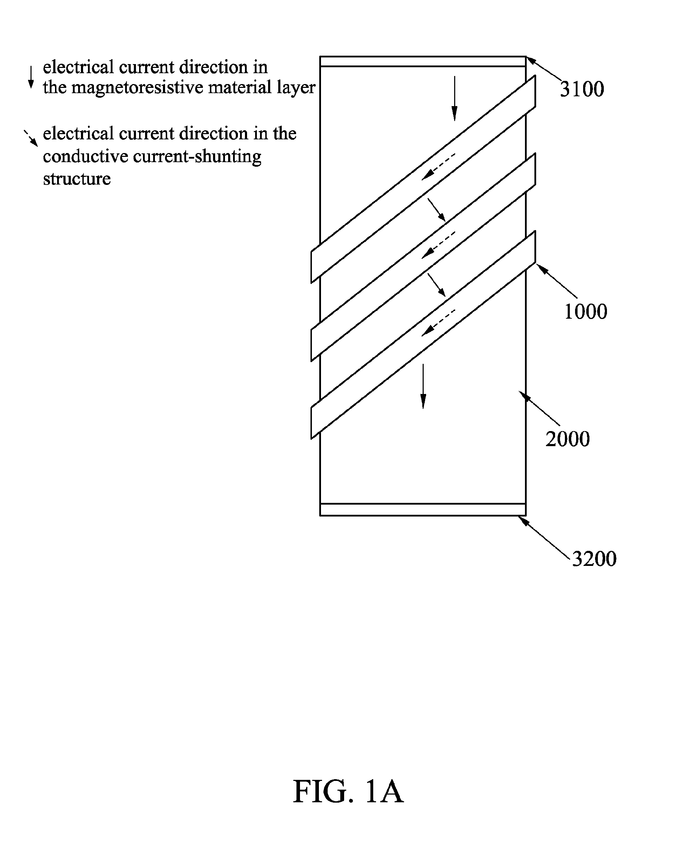

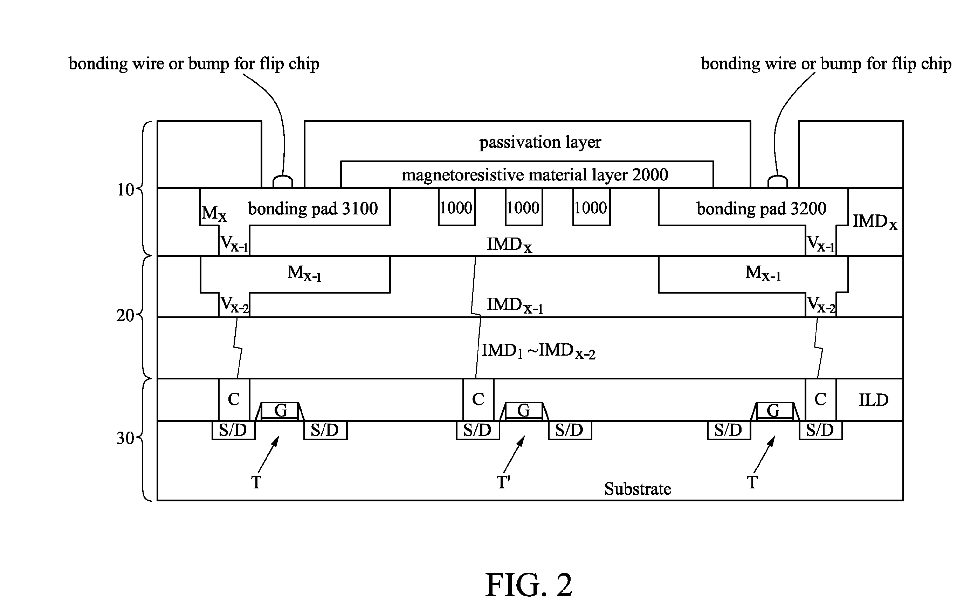

Now please refer to Fig. 1 and Fig. 2. Fig. 1 shows the schematic diagram illustrating the anisotropic magnetoresistive device 100 according to one embodiment of the present invention. Fig. 2 shows the schematic cross-sectional view of the anisotropic magnetoresistive device 100 taken along line A-A' of fig. 1 according to the first embodiment of the present invention. Fig. 1 focuses on the shape and orientation of each element of the anisotropic magnetoresistive device 100. Fig. 2 focuses on the relative locations of each element of the anisotropic magnetoresistive device 100 and environmental elements around the device 100. In Fig. 1, it is clear that the anisotropic magnetoresistive device 100 capable of sensing an external magnetic field of a direction mainly comprises a magnetoresistive material layer 2000, a conductive current-shunting structure 1000 and electrodes 3100 and 3200.

The magnetoresistive material layer 2000 can be designed to be a long strip disposed above the surface of a substrate and substantially parallel to the substrate surface. The strip of the magnetoresistive material layer 2000 takes a form of long narrow thin sheet without limitations on the shape of its ends. The magnetoresistive material layer 2000 is usually made from permalloy, but the ratio of cobalt, nickel and iron can vary according to the requirements on magnetoresistance sensitivity, mechanical properties, linearity, switching field, etc. The area size, length/width ratio, film thickness of the magnetoresistive material layer 2000 would all affect the magnetization process and the performance of the anisotropic magnetoresistive device 100. Therefore, it is possible to design the area size, length/width ratio and/or film thickness of the magnetoresistive material layer 2000 and other factors to achieve desired performance of the anisotropic magnetoresistive device 100. Generally, depending on the applications and performance required, the magnetoresistive material layer 2000 has a width ranging from several micron meters to several tens of micron meters, a length ranging from several tens of micron meters to several hundreds of micron meters, and a film thickness ranging from several hundreds of Angstrom to several thousands of Angstrom.

The conductive current-shunting structure 1000 is disposed right under the magnetoresistive material layer 2000 and physically connected thereto in such a way that the length direction of the conductive current-shunting structure 1000 is not parallel to the length direction the magnetoresistive material layer 2000. When the anisotropic magnetoresistive device 100 is in operation, the conductive current-shunting structure 1000 would change the direction of electrical current flowing in the magnetoresistive material layer 2000. By doing so, the changed direction of electrical current would form an angle with respect to the length direction of the magnetoresistive material layer 2000, so the sensing sensitivity of the anisotropic magnetoresistive device 100 would be increased. The conductive current-shunting structure 1000 comprises a plurality of conductive strips parallel to each other. These conductive strips are disposed along the length direction of the magnetoresistive material layer 2000 and extend from one side to the opposite side of the magnetoresistive material layer 2000. In order to maximize the sensing sensitivity of the anisotropic magnetoresistive device 100, the length direction of the conductive current-shunting structure 1000 forms about 45 degree with respect to the length direction of the magnetoresistive material layer 2000. However, the present invention is not limited thereto. The conductive current-shunting structure 1000 may take other forms/shapes and/or may be not parallel to each other due to performance concerns, layout concerns or other factors. Similarly, the arrangement of the conductive current-shunting structure 1000 is not limited thereto. The conductive strips of the conductive current-shunting structure 1000 may extend from one side but not reach the opposite side of the magnetoresistive material layer 2000. As further explained in the paragraphs below, since the conductive current-shunting structure 1000 is composed of the topmost metal interconnect layer of the interconnect structure, it is substantially made of material(s) commonly used for metal interconnect process comprising but not limited to copper, tungsten, aluminum, titanium, titanium nitride, tantalum, tantalum nitride and/or a combination thereof. Similarly, the thickness of the conductive current-shunting structure 1000 is the same as the thickness of the topmost metal interconnect layer ranging from several thousands of Angstrom to several micron meters. Because the resistivity of the magnetoresistive material layer 2000 is several times or even ten times greater than the resistivity of the conductive current-shunting structure 1000, the length, width and amount of the conductive current-shunting structure 1000 would change the contacting area between the conductive current-shunting structure 1000 and the magnetoresistive material layer 2000 hence the overall resistance of the anisotropic magnetoresistive device 100. Therefore, in order to achieve desired sensitivity and performance, it is necessary to wisely choose the length, width and amount of the conductive current-shunting structure 1000.

Electrodes 3100 and 3200 are electrically coupled or physically connected to two ends of the magnetoresistive material layer 2000 to apply potentials V1 and V2. Electrical current flowing through the anisotropic magnetoresistive device 100 can be sensed by applying the potential difference between potentials V1 and V2. Or, potential difference between the electrodes 3100 and 3200 can be sensed by applying a known electrical current. The resistivity of the electrodes 3100 and 3200 should be much lower than the resistivity of the magnetoresistive material layer 2000. In the fig. 2 of the first embodiment, the electrodes 3100 and 3200 are bonding pads physically connected to the magnetoresistive material layer 2000. In this embodiment, the electrodes 3100, 3200 and the conductive current-shunting structure 1000 are all parts of the topmost metal interconnect layer and share the same material(s) comprising but not limited to copper, tungsten, aluminum, titanium, titanium nitride, tantalum, tantalum nitride and/or a combination thereof. However, the present invention is not limited thereto. The electrodes 3100 and 3200 may be a part of a metal interconnect layer physically connected to the magnetoresistive material layer 2000 but electrically coupled to bonding pads through the same metal interconnect layer or other metal interconnect layer by re-routing.

Now please refer to Fig. 1A. Fig. 1A shows the schematic diagram illustrating the current flow within the anisotropic magnetoresistive device 100 according to one embodiment of the present invention. Since the conductive current-shunting structure 1000 is substantially made of at least a conductive metal whose resistivity is smaller than the resistivity of the magnetoresistive material layer 2000, in the area where the conductive current-shunting structure 1000 is physically connected to the magnetoresistive material layer 2000 electrical current would take the conductive current-shunting structure 1000 as current path due to its less resistivity while in the area where none of the conductive current-shunting structure 1000 is physically connected to the magnetoresistive material layer 2000 (that is, in the area between the adjacent conductive strips of the conductive current-shunting structures 1000) electrical current would take the magnetoresistive material layer 2000 as current path and flow from one conductive strip to the next conductive strip of the conductive current-shunting structure 1000 by beeline distance. Therefore, the magnetoresistive material layer 2000 and the conductive current-shunting structure 1000 together form a conducting path: the magnetoresistive material layer 2000→ a conductive strip of the conductive current-shunting structure 1000→ the magnetoresistive material layer 2000 between adjacent conductive strips of the conductive current-shunting structure 1000→ the next conductive strip of the conductive current-shunting structure 1000···.

Now please refer to Fig. 2 in order to understand the relative locations of each element of the anisotropic magnetoresistive device 100 and environmental elements around the device 100. Fig. 2 also illustrates a manufacturing method for forming the the anisotropic magnetoresistive device 100. In Fig. 2, lower portion 30, middle portion 20 and upper portion 10 are defined in a wafer from bottom to top. The lower portion 30 comprises a substrate, an active device (such as transistors T and T' shown in Fig. 2), an inter-layer dielectric layer (ILD) and a contact plug C embedded in the ILD. The middle portion 20 comprises inter-metal dielectric layers IMD₁-IMDₓ₋₁ and most of the interconnect structure (metal wiring layers M₁-Mₓ₋₁, metal via layers V₁-Vₓ₋₂, etc.), wherein x is an integer greater than 3. The upper portion 10 comprises inter-metal dielectric layer IMDₓ, rest of the interconnect structure (the metal wiring layer Mₓ and the metal via layer Vₓ₋₁), the magnetoresistive material layer 2000 and an optional passivation layer (not shown) formed on the magnetoresistive material layer 2000 and an optional redistribution layer (RDL, not shown). It is noted that there is no metal interconnect layers disposed above the magnetoresistive material layer.

First, a substrate is provided. The substrate may be a semiconductor substrate, a SiGe substrate, an III-V semiconductor substrate, a silicon on insulator (SOI) substrate or a composite substrate. Then, transistors T and T' are formed on the substrate and each of them comprises a gate terminal, source terminal and drain terminal. However, the active devices are not limited thereto. Active devices may comprise diodes, memory cells, bipolar junction transistor, high-voltage (HV) transistor and various circuitries such as sense amplifier, electrostatic discharge (ESD) protecting circuit and impedance matching circuit. Next, the inter-layer dielectric (ILD) layer is formed on the substrate to cover the transistors T and T'. The ILD layer may be a single-layered or multi-layered structure and it may comprise but not limited to silicon nitride (SiN), silicon dioxide (SiO2), oxide formed by tetraethyl orthosilicate (TEOS), undoped silicate (USG), phosphor-doped silicate (PSG), boro-phospho-silicate-glass (BPSG), silicon oxynitride (SiON), silicon carbide (SiC), nitrogen-doped silicon carbide (SiCN), spin-on glass (SOG), dielectric materials with low dielectric constant (low-k dielectric) such as Black diamond™ by Applied Material and SiLK™ by Dow Chemical and a random combination thereof. Next, a contact plug C is formed penetrating the ILD layer to electrically connect the terminals of transistors T or T' and the interconnect structure. The contact plug C is usually formed by a single damascene process and comprises but not limited to polysilicon, tungsten, copper, titanium, titanium nitride, tantalum, tantalum nitride and a random combination thereof.

In the embodiment of Fig. 2, the inter-metal dielectric layers IMD₁-IMDₓ₋₁ and the interconnect structure (metal wiring layers M₁-Mₓ₋ and metal via layers V₁-Vₓ₋₁) are formed by damascene processes. Although some of the inter-metal dielectric layers and a part of the interconnect structure are omitted from the Fig. 2, they can be summarized simply. Except the first metal wiring layer M₁, others of the interconnect structure are similar with the metal wiring layer Mₓ₋₁ and the metal via layer Vₓ₂ that are integral structures with a metal wiring layer and a metal via layer formed in one structure. Generally, the first metal wiring layer M₁ (not shown in any figures) is a separate structure formed by a single damascene process and would be in physically contact with the lower contact plug C somewhere and would be in physically contact with the upper metal via V₁ somewhere. The first metal wiring layer M₁ may be formed by the following steps. First, the first inter-metal dielectric layer IMD₁ of one or more dielectric materials is formed on the substrate to cover the ILD layer and the contact plug C. Then, trench patterns are formed in the IMD₁ by at least one lithography process and at least one etching process. Next, optional barrier layer(s), optional glue layer(s), an optional seed layer are formed lining the bottom and sidewall of the trench patterns and a low-resistivity metal such as copper or tungsten is formed filling up the trench patterns by either an electroplating process or a chemical vapor deposition process. Finally, a chemical mechanical polishing process is performed to remove the barrier layer(s), the glue layer(s), the seed layer and the low-resistivity metal above the IMD₁ so as to complete the first metal wiring layer M₁ and the first inter-metal dielectric layer IMD₁ having substantially coplanar top surfaces. The dielectric materials used for the inter-metal dielectric layers IMD₁-IMDₓ are similar to the dielectric materials used for the inter-layer dielectric layer ILD, so their details are omitted to avoid repetition. The methods used to form the metal wiring layer Mₓ₋₁ and the metal via layer Vₓ₋₂ are similar to but different from the method used to form the first metal wiring layer M₁. The trench patterns formed in the inter-metal dielectric layer IMDₓ₋₁ are for both the metal wiring layer Mₓ₋₁ and the metal via layer Vₓ₋₂.

The methods used to form the inter-metal dielectric layer IMDₓ, rest of the interconnect structure (the metal wiring layer Mₓ which is the topmost metal interconnect layer and the metal via layer Vₓ₋₁) of the upper portion 10 are similar to the methods used to form inter-metal dielectric layers and interconnect structure of middle portion 20, so their detail would be omitted to avoid repetition. The topmost metal interconnect layer Mₓ is different from other metal wiring layers M₁-Mₓ₋₁ due to its conclusion of the bonding pads 3100 and 3200 and the conductive current-shunting structure 1000. After being chemical mechanical polished, the upper primary surfaces of the bonding pads 3100 and 3200 and the conductive current-shunting structure 1000 are substantially coplanar with the upper primary surface of the inter-metal dielectric layer IMDₓ and exposed. Then, one or more magnetoresistive materials are blanketly formed on the inter-metal dielectric layer IMDₓ and the metal wiring layer Mₓ which comprises the bonding pads 3100 and 3200 and the conductive current-shunting structure 1000 by at least one physical vapor deposition process or other processes. Next, at least one lithography process and at least one etching process are performed on the magnetoresistive material(s) to complete the magnetoresistive material layer 2000. Finally, a passivation layer is blanketly formed on the magnetoresistive material layer 2000 to protect the magnetoresistive material layer 2000. Thereafter, at least one lithography process and at least one etching process are performed to form openings to expose the bonding pads 3100 and 3200 for further wire bonding or flip chip bumping. Or, after forming the openings and before wire bonding or flip chip bumping, optional redistribution layer(s) (RDL) may be formed to connect the formed bonding pads 3100 and 3200 to a gold pad (Au pad) or bump to be formed.

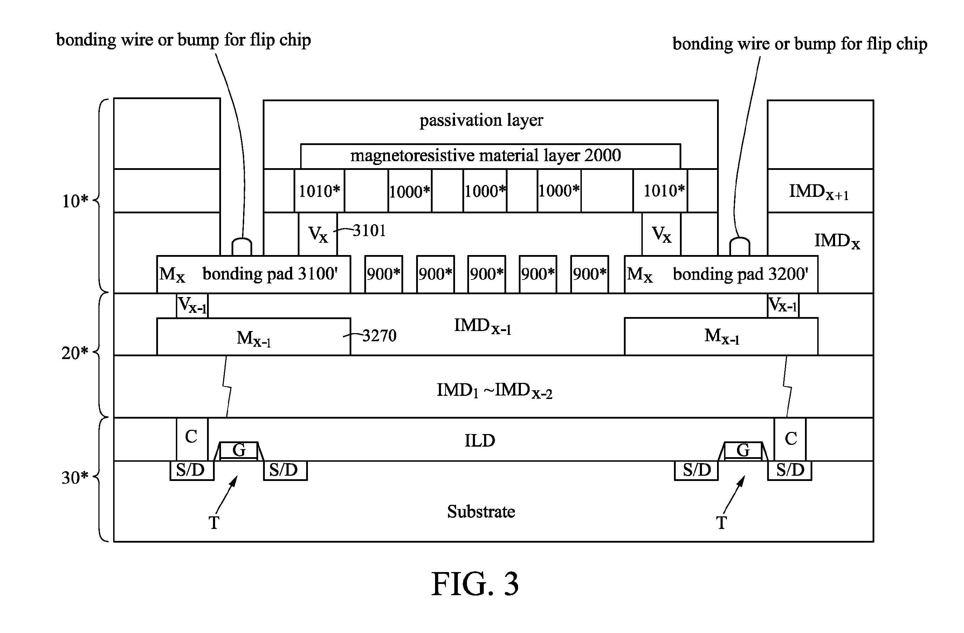

Now please refer to Fig. 3. Fig. 3 shows the schematic cross-sectional view of the anisotropic magnetoresistive device 100 taken along line A-A' of Fig. 1 according to the second embodiment of the present invention. In order to understand the relative locations of each element of the anisotropic magnetoresistive device 100 and environmental elements around the device 100, in Fig. 3, lower portion 30*, middle portion 20* and upper portion 10* are defined in a wafer from bottom to top. The lower portion 30* is similar to the lower portion 30 of Fig. 2, so its detail is omitted to avoid repetition. The middle portion 20* is similar to the middle portion 20 of Fig. 2 and comprises inter-metal dielectric layers IMD₁-IMDₓ₋₁ and most of the interconnect structure (metal wiring layers M₁-Mₓ₋₁ and metal via layers V₁-Vₓ₋₁ in this embodiment), wherein x is an integer equal to or greater than 3. The upper portion 10* is different from the upper portion 10 and comprises inter-metal dielectric layer IMDₓ and IMDₓ₊₁ , rest of the interconnect structure (the metal wiring layer Mₓ, the metal wiring layer Mₓ₊₁ , the metal via layer Vₓ, etc.), the magnetoresistive material layer 2000 and an optional passivation layer (not shown) formed on the magnetoresistive material layer 2000 and an optional redistribution layer (RDL, not shown). It is noted that there is no metal interconnect layers disposed above the magnetoresistive material layer.

Even though, in the embodiment of Fig. 3, the metal wiring layers M₁-Mₓ₋₁ are formed by patterning aluminum and/or other metallic materials and the metal via layers V₁-Vₓ₋₁ are formed by single damascene processes, they may also be formed with dual damascene processes adopted by Fig. 2. Some of the inter-metal dielectric layers and a part of the interconnect structure are omitted from the Fig. 3 because they are similar with the metal wiring layer Mₓ₋₁ and the metal via layer Vₓ₋₁ that are either separate structures in physical contact or integral structure formed in one structure. When the metal wiring layer Mₓ₋₁ and the metal via layer Vₓ₋₁ are formed separately, the (x-1)th metal wiring layer Mₓ₋₁ is a separate structure formed by patterning aluminum and/or other metallic materials and would be in physically contact with the immediate lower metal interconnect layer somewhere and would be in physically contact with the immediate upper metal interconnect somewhere. The (x-1)th metal wiring layer Mₓ₋₁ may be formed by the following steps. First, an aluminum layer and/or other metallic material layers are blanketly formed on the formed inter-metal dielectric layer IMDₓ₋₂. Then, at least one lithography process and at least one etching process are performed to pattern the aluminum layer and/or other metallic material layers to complete the (x-1)th metal wiring layer Mₓ₋₁. Next, the inter-metal dielectric layer IMDₓ₋₁ is formed on the (x-1)th metal wiring layer Mₓ₋₁. When the metal wiring layer Mₓ₋₁ and the metal via layer Vₓ₋₁ are formed separately, the metal via layer Vₓ₋₁ could be formed by the following steps. First, trench patterns are formed in the IMDₓ₋₁ by at least one lithography process and at least one etching process. Next, optional barrier layer(s), optional glue layer(s), an optional seed layer are formed lining the bottom and sidewall of the trench patterns and a low-resistivity metal such as copper or tungsten is formed filling up the trench patterns by either an electroplating process or a chemical vapor deposition process. Finally, a chemical mechanical polishing process is performed to remove the barrier layer(s), the glue layer(s), the seed layer and the low-resistivity metal above the IMDₓ₋₁ so as to complete the metal via layer Vₓ₋₁ and the inter-metal dielectric layer IMDₓ₋₁ having substantially coplanar top surfaces. When the metal wiring layer Mₓ₋₁ and the metal via layer Vₓ₋₁ are formed in one structure, they may adopt the methods used in Fig. 2. The materials used for the inter-metal dielectric layers IMD₁-IMDₓ are similar to the materials used for the inter-layer dielectric layer (ILD) of Fig. 2. As such, these methods and materials are not repeated here.

The methods used to form the inter-metal dielectric layer IMDₓ and IMDₓ₊₁ and rest of the interconnect structure (the metal wiring layer Mₓ, the metal via layer Vₓ and the metal wiring layer Mₓ₊₁ which is the topmost metal interconnect layer) of the upper portion 10* are similar to the methods used to form the inter-metal dielectric layers and interconnect structure of middle portion 20*, so their detail would be omitted to avoid repetition. The metal wiring layer Mₓ is different from other metal wiring layers M₁-Mₓ₋₁ due to its conclusion of the bonding pads 3100* and 3200* and an element 900*. The element 900* may be a set/reset circuit, a compensating/offset circuit and/or a built-in self-testing circuit. The metal via layer Vx is configured to electrically couple the bonding pads 3100* and 3200* to the magnetoresistive material layer 2000. The metal wiring layer Mₓ₊₁ comprises the conductive current-shunting structure 1000* and a conductive connecting structure 1010* configured to electrically couple the bonding pads 3100* and 3200* to the magnetoresistive material layer 2000. After being chemical mechanical polished, the upper primary surfaces of the conductive current-shunting structure 1000* and the conductive connecting structure 1010* are substantially coplanar with the primary upper surface of the inter-metal dielectric layer IMDₓ₊₁ and exposed. Then, one or more magnetoresistive materials are blanketly formed on the inter-metal dielectric layer IMDₓ₊₁ and the metal wiring layer Mₓ₊₁ which comprises the conductive current-shunting structure 1000* by at least one physical vapor deposition process or other processes. Next, at least one lithography process and at least one etching process are performed on the magnetoresistive material(s) to complete the magnetoresistive material layer 2000. Finally, a passivation layer is blanketly formed on the magnetoresistive material layer 2000 to protect the magnetoresistive material layer 2000. Thereafter, at least one lithography process and at least one etching process are performed to form openings to expose the bonding pads 3100* and 3200* for further wire bonding or flip chip bumping. Or, after forming the openings and before wire bonding or flip chip bumping, optional redistribution layer(s) (RDL) may be formed to connect the formed bonding pads 3100* and 3200* to a gold pad (Au pad) or bump to be formed.

It is noted in the second embodiment, although the conductive current-shunting structure 1000* is formed with the metal wiring layer Mₓ₊₁, it is made from tungsten rather than conventional patterned aluminum to achieve better shunting effects and render current distribution in the magnetoresistive material layer 2000 more uniform. In this embodiment, the set/reset circuit, compensating/offset circuit and/or built-in self-testing circuit of the element 900* is formed with the metal wiring layer Mx, but they may be formed with any metal wiring layer or any metal via layer right under the magnetoresistive material layer 2000. Moreover, this embodiment adopts an aluminum layer for the bonding pads 3100* and 3200*, so no other metal layers are required on the bonding pads to modify surface properties of the bonding pads. If a copper or tungsten layer is adopted for the bonding pads 3100* and 3200*, an extra aluminum film may be required to cover the surface of the copper or tungsten bonding pads, thereby increasing process complexity.

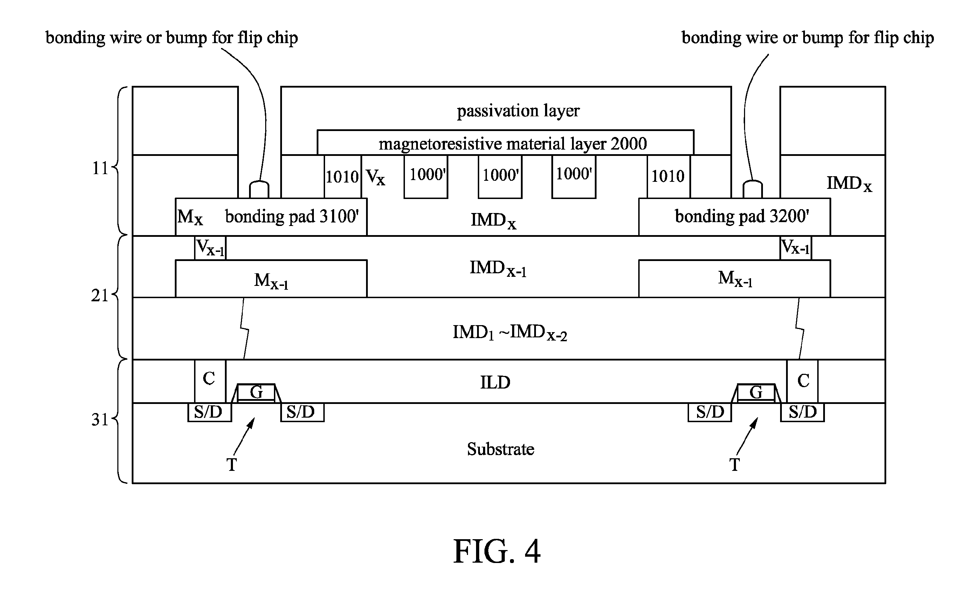

No please refer to Fig. 4. Fig. 4 shows the schematic cross-sectional view of the anisotropic magnetoresistive device 100 taken along line A-A' of Fig. 1 according to the third embodiment of the present invention. In order to understand the relative locations of each element of the anisotropic magnetoresistive device 100 and environmental elements around the device 100, lower portion 31, middle portion 21 and upper portion 11 are defined in a wafer from bottom to top. The lower portion 31 is similar to the lower portion 30 of Fig. 2 in terms of its components and manufacturing method, so its detail would be omitted. The middle portion 21 is similar to the middle portion 20 of Fig. 2 and comprises inter-metal dielectric layers IMD₁-IMDₓ₋₁ and most of the interconnect structure (metal wiring layers M₁-Mₓ₋₁ and metal via layers V₁-Vₓ₋₁), wherein x is an integer equal to or greater than 3. The upper portion 11 is similar to the upper portion 10 of Fig. 2 and comprises the inter-metal dielectric layer IMDₓ, rest of the interconnect structure (the metal wiring layer Mₓ and the metal via layer Vₓ), the magnetoresistive material layer 2000, an optional passivation layer (not shown) formed on the magnetoresistive material layer 2000 and an optional redistribution layer (RDL, not shown). It is noted that there is no metal interconnect layers disposed above the magnetoresistive material layer.

In the embodiment of Fig. 4, the metal wiring layers M₁-Mₓ are formed by patterning aluminum and/or other metallic material while the metal via layers V₁-Vₓ₋₁ are formed by single damascene processes. Although some of the inter-metal dielectric layers and a part of the interconnect structure are omitted from the Fig. 4, they can be summarized simply. All the metal interconnect layers, in terms of their structures, are similar to the metal wiring layer Mₓ₋₁ and the metal via layer Vₓ₋₁ that are separate structures in physical contact. Generally, the (x-1)th metal wiring layer Mₓ₋₁ is a separate structure formed by patterning aluminum and/or other metallic materials and would be in physically contact with the immediate lower metal interconnect layer somewhere and would be in physically contact with the immediate upper metal interconnect layer somewhere. The (x-1)th metal wiring layer Mₓ₋₁ may be formed by the following steps. First, an aluminum layer and/or other metallic material layers are blanketly formed on the formed inter-metal dielectric layer IMDₓ₋₂. Then, at least one lithography process and at least one etching process are performed to pattern the aluminum layer and/or other metallic material layers to complete the (x-1)th metal wiring layer Mₓ₋₁. Next, the inter-metal dielectric layer IMDₓ₋₁ is formed on the (x-1)th metal wiring layer Mₓ₋₁. The metal via layer Vₓ₋₁ could be formed by the following steps. First, trench patterns are formed in the IMDₓ₋₁ by at least one lithography process and at least one etching process. Next, optional barrier layer(s), optional glue layer(s), an optional seed layer are formed lining the bottom and sidewall of the trench patterns and a low-resistivity metal such as copper or tungsten is formed filling up the trench patterns by either an electroplating process or a chemical vapor deposition process. Finally, a chemical mechanical polishing process is performed to remove the barrier layer(s), the glue layer(s), the seed layer and the low-resistivity metal above the IMDₓ₋₁ so as to complete the metal via layer Vₓ₋₁ and the inter-metal dielectric layer IMDₓ₋₁ having substantially coplanar upper primary surfaces. The materials used for the inter-metal dielectric layers IMD₁-IMDₓ are similar to the materials used for the inter-layer dielectric layer (ILD) of Fig. 2. As such, these materials are not repeated here.

The methods used to form the inter-metal dielectric layer IMDₓ and rest of the interconnect structure (the metal wiring layer Mₓ and the metal via layer Vₓ which is the topmost metal interconnect layer) of the upper portion 11 are similar to the methods used to form the inter-metal dielectric layers and interconnect structure of middle portion 21, so their detail would be omitted to avoid repetition. The metal wiring layer Mₓ is different from other metal wiring layers M₁-Mₓ₋₁ due to its inclusion of the bonding pads 3100' and 3200'. The metal via layer Vx is different from other metal via layers V1-Vx-1 due to its inclusion of the conductive current-shunting structure 1000' and the conductive connecting structure 1010 configured to electrically couple the bonding pads 3100' and 3200' to the magnetoresistive material layer 2000. After being chemical mechanical polished, the upper primary surfaces of the conductive current-shunting structure 1000' and the conductive connecting structure 1010 are substantially coplanar with the upper primary surface of the inter-metal dielectric layer IMDₓ and exposed. Then, one or more magnetoresistive materials are blanketly formed on the inter-metal dielectric layer IMDₓ and the metal via layer Vₓ which comprises the conductive current-shunting structure 1000' by at least one physical vapor deposition process or other processes. Next, at least one lithography process and at least one etching process are performed on the magnetoresistive material(s) to complete the magnetoresistive material layer 2000. Finally, a passivation layer is blanketly formed on the magnetoresistive material layer 2000 to protect the magnetoresistive material layer 2000. Thereafter, at least one lithography process and at least one etching process are performed to form openings to expose the bonding pads 3100' and 3200' for further wire bonding or flip chip bumping. Or, after forming the openings and before wire bonding or flip chip bumping, optional redistribution layer(s) (RDL) may be formed to connect the formed bonding pads 3100' and 3200' to a gold pad (Au pad) or bump to be formed. It is noted that although the conductive current-shunting structure 1000' are formed with the metal via layer Vx, it would take strip as its shape as shown in Fig. 1 and 2 not circle or oval that are commonly taken for conductive vias.

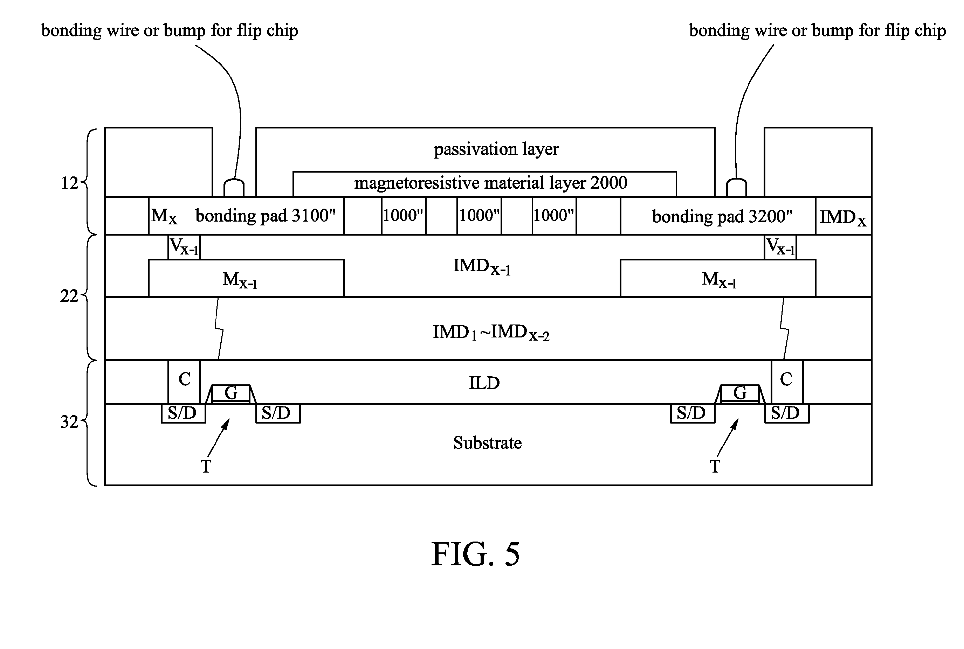

No please refer to Fig. 5. Fig. 5 shows the schematic cross-sectional view of the anisotropic magnetoresistive device 100 taken along line A-A' of Fig. 1 according to the fourth embodiment of the present invention. In order to understand the relative locations of each element of the anisotropic magnetoresistive device 100 and environmental elements around the device 100, lower portion 32, middle portion 22 and upper portion 12 are defined in a wafer from bottom to top. The lower portion 32 is similar to the lower portion 30 of Fig. 2 and the lower portion 31 of Fig. 4 in terms of its components and manufacturing method, so its detail would be omitted. The middle portion 22 is similar to the middle portion 21 of Fig. 4 in terms of its components and manufacturing method, so its detail would be omitted. The upper portion 12 comprises the inter-metal dielectric layer IMDₓ, rest of the interconnect structure (the metal wiring layer Mₓ), the magnetoresistive material layer 2000, an optional passivation layer (not shown) formed on the magnetoresistive material layer 2000 and an optional redistribution layer (RDL, not shown). It is noted that there is no metal interconnect layers disposed above the magnetoresistive material layer.

The methods used to form the inter-metal dielectric layer IMDₓ and rest of the interconnect structure (the metal wiring layer Mₓ which is the topmost metal interconnect layer) of the upper portion 12 are similar to the methods used to form the inter-metal dielectric layers and interconnect structure of middle portion 22, so their detail would be omitted to avoid repetition. The metal wiring layer Mₓ is different from other metal wiring layers M₁-Mₓ₋₁ due to its inclusion of the bonding pads 3100" and 3200" and the conductive current-shunting structure 1000". In order to expose the upper surfaces of the bonding pads 3100" and 3200" and the conductive current-shunting structure 1000", after forming the metal wiring layer Mₓ by patterning aluminum and/or other metallic materials and forming an inter-metal dielectric layer IMDₓ to cover the metal wiring layer Mₓ, a chemical mechanical polishing process is performed on the inter-metal dielectric layer IMDₓ until exposing the upper surface of the metal wiring layer Mₓ. After being chemical mechanical polished, the upper primary surfaces of the bonding pads 3100" and 3200" and the conductive current-shunting structure 1000" are substantially coplanar with the upper primary surface of the inter-metal dielectric layer IMDₓ and exposed. Then, one or more magnetoresistive materials are blanketly formed on the inter-metal dielectric layer IMDₓ and the metal wiring layer Mₓ which comprises the bonding pads 3100" and 3200" and the conductive current-shunting structure 1000" by at least one physical vapor deposition process or other processes. Next, at least one lithography process and at least one etching process are performed on the magnetoresistive material(s) to complete the magnetoresistive material layer 2000. Finally, a passivation layer is blanketly formed on the magnetoresistive material layer 2000 to protect the magnetoresistive material layer 2000. Thereafter, at least one lithography process and at least one etching process are performed to form openings to expose the bonding pads 3100" and 3200" for further wire bonding or flip chip bumping. Or, after forming the openings and before wire bonding or flip chip bumping, optional redistribution layer(s) (RDL) may be formed to connect the formed bonding pads 3100" and 3200" to a gold pad (Au pad) or bump to be formed. It is noted that out of all the metal wiring layers M₁-Mₓ only the metal wiring layer Mₓ is planarized because the conductive current-shunting structure 1000" has to be exposed from the inter-metal dielectric IMDₓ and the anisotropic magnetoresistive device 100 requires good flatness for its sensing performance.

In the embodiments of Figs. 2-5, active devices such as transistors and memory cells may be disposed right under the bonding pads and/or magnetoresistive material layer 2000 to make better use of the precious layout space and reduce chip size. In the embodiments of Figs. 2-5, a set/reset circuit, a compensating (offset) circuit and/or a built-in self-testing (BIST) circuit may be disposed right under or above the magnetoresistive material layer 2000 and may be formed with anyone of the metal interconnect layers and the optional redistribution layer. In the embodiments of Figs. 2-5, dummy patterns may be optionally inserting within anyone or each one of the metal interconnect layers in order to reduce micro-loading effects that may occur during etching processes and/or chemical mechanical polishing processes. The dummy patterns in the context of the present invention refer to patterns that are electrically isolated from the active devices, magnetoresistive material layer, circuits and passive devices. In the embodiments of Figs. 2-5, dielectric slots may be embedded in bulk metal patterns in order to reduce tensile/compressive stress and/or reduce dishing effects that may occur during chemical mechanical polishing processes.

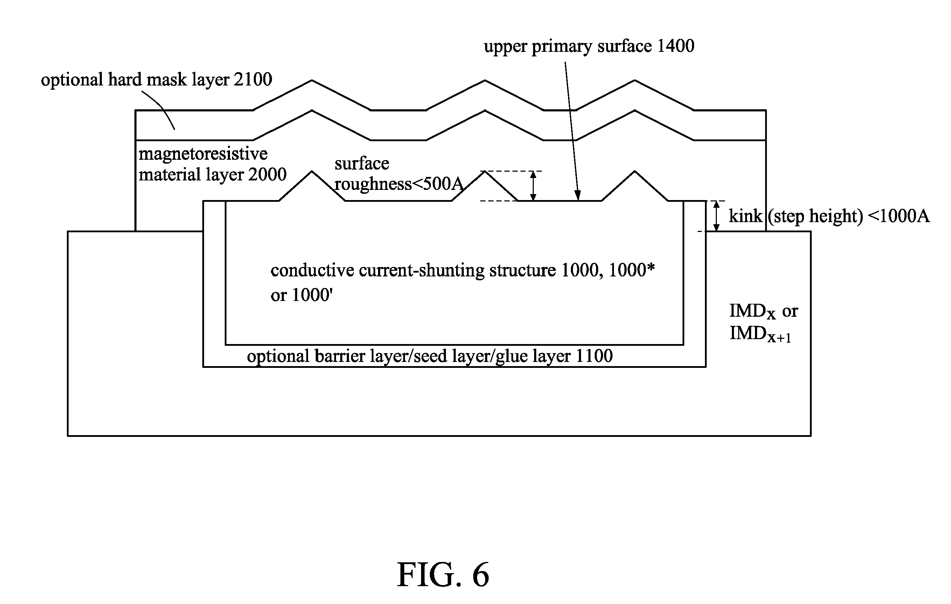

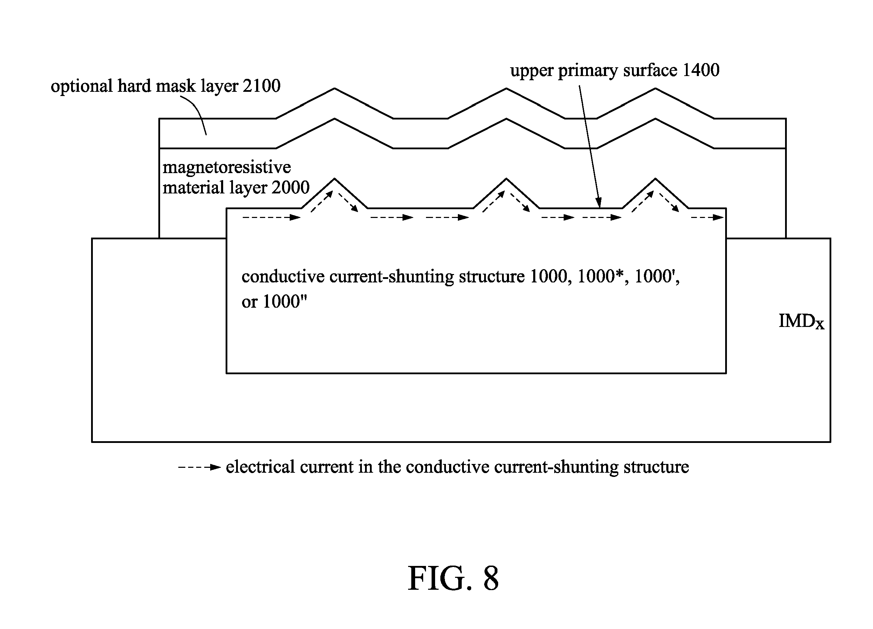

Now please refer to Figs. 6 and 8. Fig. 6 shows the enlarged cross-sectional view of the boundary between the magnetoresistive material layer and the conductive current-shunting structure of Fig. 2 or fig. 4. Fig. 8 shows the current flowing within the conductive current-shunting structures of Figs. 2-5. In Fig. 6, the conductive current-shunting structures 1000, 1000* and 1000' embedded in the inter-metal dielectric layer IMDₓ or IMDₓ₊₁ are formed by damascene processes and covered by the patterned magnetoresistive material layer 2000. The conductive current-shunting structures 1000, 1000* and 1000' are formed with at least one low-resistivity metal such as copper or tungsten and the sidewalls and bottom surface of the low-resistivity metal of the conductive current-shunting structures 1000, 1000* and 1000' may be optional against an optional thin layer 1100. This optional thin layer 1100 may comprise a barrier layer and/or a seed layer and/or a glue layer. The optional barrier layer and glue layer may comprise but are not limited to titanium, titanium nitride, tantalum, tantalum nitride, etc. The optional seed layer may be a tungsten layer or a copper layer formed by a physical vapor deposition process. An optional hard mask layer 2100 may be formed on the patterned magnetoresistive material layer 2000 before its patterning process in order to protect the magnetoresistive material(s) during the patterning process and keep the sidewall profile of the patterned magnetoresistive material layer 2000. Since the hard mask layer 2100 is only configured to facilitate the patterning process of the magnetoresistive material layer 2000 not configured to be used for other layers such as the metal interconnect layers, the thickness of the hard mask layer 2100 may be reduced to less than 100 Angstroms. Because a material used for the hard mask layer 2100 usually has higher resistivity than the resistivity of the magnetoresistive material layer 2000, using such a thin hard mask layer 2100 would improve the sensitivity of the anisotropic magnetoresistive device.

After being chemical mechanical polished, the conductive current-shunting structures 1000, 1000* and 1000' shown in the Fig. 2, 3 and 4 should have their upper primary surfaces 1400 coplanar with the upper primary surfaces of the inter-metal dielectric layer IMDₓ or IMDₓ₁. However, in fact, due to different materials used by the conductive current-shunting structure and the inter-metal dielectric layer, selection of polishing slurry and/or selections of polishing parameters, there would be a kink (step height) between the upper primary surfaces 1400 and the upper primary surfaces of the inter-metal dielectric layer IMDₓ or IMDₓ₁. In the present invention, this kink (step height) is reduced to be less than 1000 Angstrom by selecting the polishing slurry used and/or by tuning the polishing parameters used.

In addition, many factors would affect the chemical mechanical polishing process performed on the conductive current-shunting structures 1000, 1000* and 1000', so surface roughness 1500 such as hillock, scratch mark, erosion and bulging on the polished upper primary surfaces of the conductive current-shunting structures 1000, 1000* and 1000' may be created. These factors include but are not limited to: deposition process used to form low-resistivity metal such as copper, tungsten and aluminum of the conductive current-shunting structures 1000, 1000* and 1000'; polishing parameters used; polishing slurry used; electrochemical reactions between the polishing slurry and the low-resistivity metal subject to polishing. Please refer to Fig. 8. When the surface roughness 1500 exists in the conductive current-shunting structures 1000, 1000*, 1000' or 1000", the later-formed magnetoresistive material layer 2000 would conform with the surface profile of the conductive current-shunting structures 1000, 1000*, 1000' or 1000". That is, the interface between the magnetoresistive material layer 2000 and the conductive current-shunting structures 1000, 1000*, 1000' or 1000" is not completely flat but with fluctuations. This would cause the current flowing in the conductive current-shunting structures 1000, 1000*, 1000' or 1000" to have various directions, thereby causing random magnetic moments. Since the anisotropic magnetoresistive device senses an external magnetic field applied based on an included angle between the direction of electrical current and the direction of the external magnetic field applied, disturbing the direction of the electrical current would disturb the sensing result and create more sensing errors.

In the present invention, the surface roughness 1500 of the upper primary surface 1400 is reduced to be less than 500 Angstrom by controlling the following factors: deposition process used to form the low-resistivity metal such as copper, tungsten and aluminum of the conductive current-shunting structures 1000, 1000* and 1000'; polishing parameters used; polishing slurry used; electrochemical reactions between the polishing slurry and the low-resistivity metal subject to polishing. Specifically, lower deposition temperature can be adopted to form the low-resistivity metal such as copper, tungsten and aluminum of the conductive current-shunting structures 1000, 1000* and 1000' so the low-resistivity metal such as copper, tungsten and aluminum has smaller grain hence smoother surface. Specifically, lower down force can be adopted during the chemical mechanical polishing process performed on the conductive current-shunting structures 1000, 1000* and 1000' so smoother polished surface is obtained. Specifically, lower concentration of oxidant can be adopted for the polishing slurry used on the conductive current-shunting structures 1000, 1000* and 1000' so smoother polished surface is obtained. It is noted that one or more of the factors can be controlled in order to reduce the surface roughness 1500.

When the upper primary surface 1400 of the conductive current-shunting structure and the upper primary surface of the inter-metal dielectric layer IMDₓ or IMDₓ₁ are more coplanar (that is, the kink /step height between the upper primary surface 1400 of the conductive current-shunting structure and the upper primary surface of the inter-metal dielectric layer IMDₓ or IMDₓ₁.) and the conductive current-shunting structure is smoother (that is, the surface roughness 1500 of the upper primary surface 1400 is less), the boundary between the magnetoresistive material layer 2000 and the conductive current-shunting structure is flatter. Due to this flatter boundary, currents flowing in the conductive current-shunting structures 1000, 1000*, 1000' or 1000" can have consistent directions, thereby leading to consistent magnetic moments. Therefore, better performance of the anisotropic magnetoresistive device can be achieved.

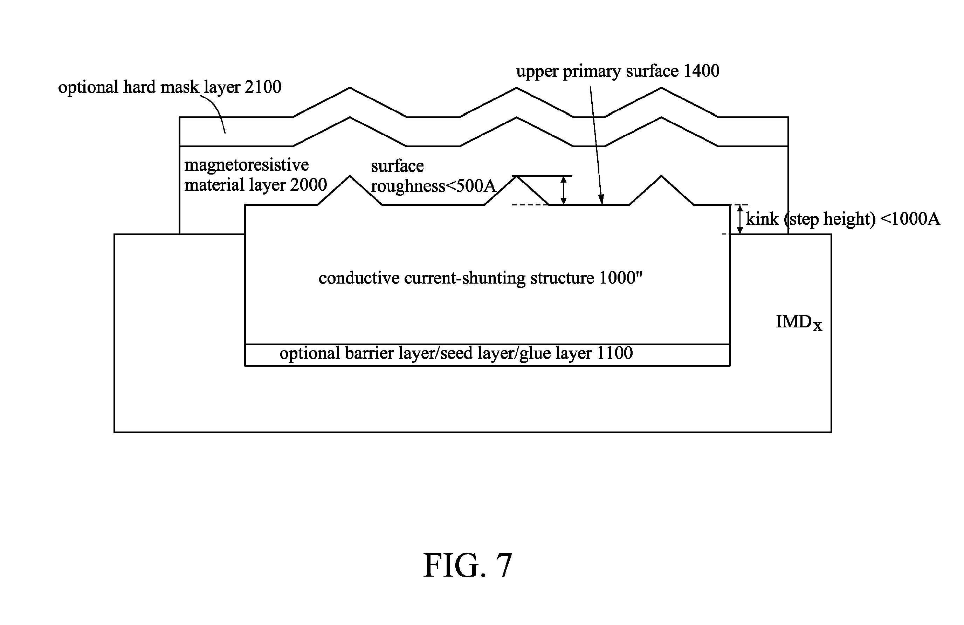

Now please refer to Fig. 7. Fig. 7 shows the enlarged cross-sectional view of the boundary between the magnetoresistive material layer and the conductive current-shunting structure of Fig. 5. Fig. 7 shares the same requirements with Fig. 6 for the kink (step height) and the surface roughness 1500. The difference between Fig. 7 and Fig. 6 mainly lies in their optional barrier layer/seed layer/glue layer 1200. In Fig. 7, the conductive current-shunting structure 1000" is formed by patterned aluminum and/or other metallic materials, so sidewalls of the patterned aluminum and/or other metallic materials are not surrounded by optional barrier layer/seed layer/glue layer. The optional barrier layer/seed layer/glue layer is only disposed below the patterned aluminum and/or other metallic materials.

In summary, in the anisotropic magnetoresistive device according to various embodiments of the present invention, the magnetoresistive material layer is former after the completion of the front end of line (FEOL) and the back end interconnect processes. Therefore, the magnetoresistive material used for the magnetoresistive material layer containing magnetic species such as iron, cobalt and nickel can not contaminate machines used for the front end of line and back end interconnect processes. Moreover, since the front end of line and back end interconnect processes are completed before forming the magnetoresistive material layer, the processes, materials, parameters used in the front end of line and back end interconnect processes can not affect the magnetoresistive material layer formed later.

Furthermore, the present invention controls the surface roughness of the upper primary surface of the conductive current-shunting structure which is at the boundary between the magnetoresistive material layer and the conductive current-shunting structure and controls the kink (step height) between the upper primary surface of the conductive current-shunting structure and the upper primary surfaces of the inter-metal dielectric layer IMDₓ or IMDₓ₁, so currents following in the current-shunting structure during operation of the anisotropic magnetoresistive device can have better orientation and distribution, thereby achieving better performance of the anisotropic magnetoresistive device.

While the invention has been described in terms of what is presently considered to be the most practical and preferred embodiments, it is to be understood that the invention needs not be limited to the disclosed embodiment. On the contrary, it is intended to cover various modifications and similar arrangements included within the spirit and scope of the appended claims which are to be accorded with the broadest interpretation so as to encompass all such modifications and similar structures.

## Claims

1. An anisotropic magnetoresistive (AMR) device comprising:
a substrate;
an interconnect structure, disposed above the substrate and comprising a plurality of metal interconnect layers; and
a magnetoresistive material layer (2000), disposed above the interconnect structure,
wherein a topmost metal interconnect layer of the plurality of metal interconnect layers comprises a conductive current-shunting structure (1000/1000*/1000'/1000"), whereby the conductive current-shunting structure (1000/1000*/1000'/1000") is physically connected to the magnetoresistive material layer (2000) without a conductive via plug.

2. The anisotropic magnetoresistive (AMR) device according to claim 1, wherein no metal interconnect layers are disposed above the magnetoresistive material layer (2000).

3. The anisotropic magnetoresistive (AMR) device according to claim 1 or 2, further comprising a hard mask layer (2100) and a passivation layer disposed above the magnetoresistive material layer.

4. The anisotropic magnetoresistive (AMR) device according to any one of claims 1-3,
wherein the topmost metal interconnect layer further comprises a bonding pad (3100/3100"/3200/3200"); or
further comprising a metal interconnect layer having a bonding pad (3100*/3100'/3200*/3200'), wherein this metal interconnect layer is different from the topmost metal interconnect layer.

5. The anisotropic magnetoresistive (AMR) device according to any one claims 1-4, wherein the topmost metal interconnect layer is substantially made of copper or tungsten or aluminum.

6. The anisotropic magnetoresistive (AMR) device according to any one of claims 1-5, wherein the plurality of metal interconnect layers further comprise a set/reset circuit (900*), a compensating circuit (900*) and/or a built-in self-testing circuit (900*) disposed right under the magnetoresistive material layer (2000),
preferably further comprising a bonding pad (3100*/3200*) within a metal interconnect layer which comprises the set/reset circuit (900*), a compensating circuit (900*) and/or a built-in self-testing circuit (900*).

7. The anisotropic magnetoresistive (AMR) device according to any one of claims 1-6, further comprising a redistribution layer above the magnetoresistive material layer (2000).

8. The anisotropic magnetoresistive (AMR) device according to any one of claims 1-7, wherein the magnetoresistive material layer (2000) is made from Permalloy.

9. The anisotropic magnetoresistive (AMR) device according to any one of claims 1-8, wherein a surface roughness of the conductive current-shunting structure (1000/1000*/1000'/1000") at a boundary between the conductive current-shunting structure (1000/1000*/1000'/1000") and the magnetoresistive material layer (2000) is less than 500 Angstroms.

10. The anisotropic magnetoresistive (AMR) device according to any one of claims 1-9, wherein the conductive current-shunting structure (1000/1000*/1000'/1000") is embedded in an inter-metal dielectric layer and a kink (step height) between an upper primary surface of the conductive current-shunting structure (1000/1000*/1000'/1000") and an upper primary surface of the inter-metal dielectric layer (IMDₓ/IMDₓ₊₁/Vₓ) is less than 1000 Angstroms.

11. The anisotropic magnetoresistive (AMR) device according to any one of claims 1-10, wherein the plurality of metal interconnect layers comprises a plurality of metal wiring layers and a plurality of metal via layers, the topmost metal interconnect layer is one of the wiring layers not one of the metal via layers;
preferably wherein active devices (T) are disposed right under the magnetoresistive material layer (2000).

12. A method for forming an anisotropic magnetoresistive (AMR) device comprising:
providing a substrate;
forming an interconnect structure disposed above the substrate and comprising a plurality of metal interconnect layers; and
forming a magnetoresistive material layer (2000) above the interconnect structure,
wherein a topmost metal interconnect layer of the plurality of metal interconnect layers comprises a conductive current-shunting structure (1000/1000*/1000'/1000"), whereby the conductive current-shunting structure (1000/1000*/1000'/1000") is physically connected to the magnetoresistive layer (2000) without a conductive via plug.

13. The method for forming an anisotropic magnetoresistive (AMR) device according to claim 12, further comprising:
before forming the magnetoresistive layer (2000), performing a chemical mechanical polishing process to the topmost interconnect layer.

14. The method for forming an anisotropic magnetoresistive (AMR) device according to claim 13,
further comprising:
controlling at least one of the following parameters while forming the topmost metal interconnect layer so as to make a surface roughness of a upper primary surface of the topmost metal interconnect layer less than 500 Angstroms:
temperature used to depositing the topmost metal interconnect layer;
concentration of an oxidant of a polishing slurry used in the chemical mechanical polishing process; and
down force used in the chemical mechanical polishing process;
or
further comprising:
controlling at least one of the following parameters while forming the topmost metal interconnect layer so as to make a kink (step height) between an upper primary surface of the topmost metal interconnect layer and an upper primary surface of an inter-metal dielectric layer (IMDₓ/IMDₓ₊₁/Vₓ) in which the conductive current-shunting structure (1000/1000*/1000'/1000") is embedded less than 1000 Angstroms:
temperature used to depositing the topmost metal interconnect layer;
concentration of an oxidant of a polishing slurry used in the chemical mechanical polishing process; and
down force used in the chemical mechanical polishing process.

15. The method for forming an anisotropic magnetoresistive (AMR) device according to claim 12,
further comprising: forming a bonding pad in one of the metal interconnect layers which is different from the topmost metal interconnect layer, preferably wherein the magnetoresistive layer (2000) is electrically connected to the bonding pad (3100*/3100') through a patterned metal structure (1010*/1010); or
wherein the conductive current-shunting structure (1000/1000*/1000'/1000") is formed by a damascene process; or
wherein the conductive current-shunting structure (1000/1000*/1000') is substantially made from copper or tungsten; or
wherein the conductive current-shunting structure (1000") is formed by patterning aluminum.
